# EUROPEAN PATENT APPLICATION

(11) **EP 4 418 047 A2**
(43) Date of publication of application: **21.08.2024**
(21) Application number: 24168118.8
(22) Date of filing: 18.11.2020
(51) Int. Cl.: G03F 7/20

(54) **METHOD AND APPARATUS FOR CURING A PRINTING PLATE**

(30) Priority: 22.07.2020 EP 20187095
(62) Divisional of application: 20804583.1
(71) Applicant: Esko-Graphics Imaging GmbH, 25524 Itzehoe (DE)
(72) Inventor: WOLTERINK, Jörg, 25524 Oelixdorf (DE); HÄNSEL, Thomas, 25335 Elmshorn (DE); GREVE, Christian, 25524 Itzehoe (DE); GREWLING, Frank, 25524 Breitenberg (DE); KLEIN, Thomas, 38302 Wolfenbuettel (DE)
(74) Representative: Müller-Boré & Partner Patentanwälte PartG mbB

(57) **Abstract**

An aspect related to a method for curing a printing plate (10) comprising a photosensitive polymer layer (18) sensitive to actinic radiation and an imaging layer (22) covering the photosensitive polymer layer (18), the method comprising:
generating with a radiation source (36) a sequence of exposure cycles to expose the photosensitive polymer layer (18) through the imaging layer (22) to actinic radiation radiated from the radiation source,
wherein the sequence of exposure cycles comprises a first set of exposure cycles followed by a second set of exposure cycles, the first set of exposure cycles having a corresponding first set of intensities of the actinic radiation and the second set of exposure cycles having a corresponding second set of intensities of the actinic radiation,
wherein the intensity of the actinic radiation within the first set of intensities is lower than the intensity of the actinic radiation within the second set of intensities and/or an energy input to the photosensitive polymer layer (18) by each exposure cycle of the first set of exposure cycles is lower than the energy input of each exposure cycle of the second set of exposure cycles,
wherein the second set of exposure cycles comprises equal or more exposure cycles than the first set of exposure cycles, and
wherein the energy input of the first set of exposure cycles is about 10% to 30% of the energy input of the sequence of exposure cycles.

## Description

The present invention relates to methods and apparatuses for curing a printing plate.

Methods for preparing a printing plate comprising a photosensitive polymer layer, such as a photopolymer flexographic plate and a letterpress printing plate coated with a photosensitive polymer layer, usually comprises an imaging step for transferring image information to the printing plate. In a later printing process after the printing plate has been prepared, the prepared printing plate may allow printing of images according to the image information. Specifically, the transferred image information determines, where printing features are developed at the printing plate. Said printing features allow to transfer a print medium, e.g., printing ink, to a substrate, e.g., packaging material, paper, etc., during the printing process.

One possibility of transferring the image information during the imaging step to the printing plate is to transfer the image information to an imaging layer covering the photosensitive polymer layer. For example, the imaging layer may be impermeable to an actinic radiation which is used to cure the photosensitive polymer layer of the printing plate during a curing step subsequent to the imaging step. To transfer the image information to the imaging layer, the imaging layer may at least be partially ablated according to the image information, e.g., by using a laser. Accordingly, during the curing step, the actinic radiation may enter the photosensitive polymer layer through the ablated areas of the imaging layer, wherein remaining areas of the imaging layer, i.e., areas which have not been ablated, prevent that the actinic radiation can enter into the photosensitive polymer layer.

Further, it is known to cure the printing plate or the photosensitive polymer layer by exposing the printing plate or the photosensitive polymer layer with actinic radiation causing the photosensitive polymer layer to cure and to develop printing features in the photosensitive polymer layer according to the image information transferred to the imaging layer. After the curing step, the printing plate usually undergoes a development step in which non-cured areas of the photosensitive polymer layer and/or the imaging layer are removed, e.g., by thermal development and/or by washing the non-cured areas of the photosensitive polymer layer and the imaging layer with a solvent.

For example, WO 2012/010459 A1 relates to a method for curing a printing plate by exposing the printing plate to actinic radiation. Specifically, WO 2012/010459 A1 discloses to apply two exposure steps to the printing plate where in a first step the printing plate is exposed with actinic radiation having an intensity which is higher than the intensity applied in a second step after the first step.

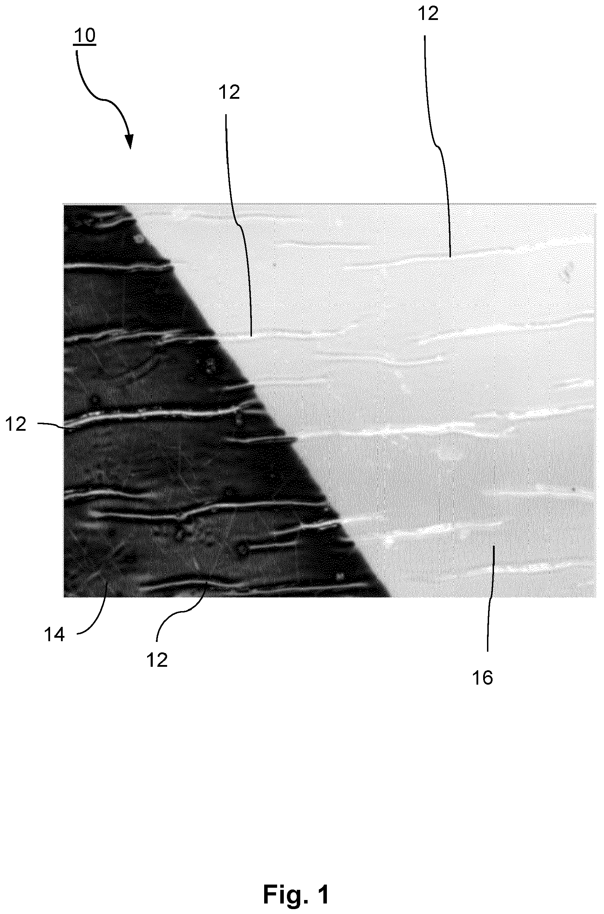

However, it has been recognized that cured printing plates may tend to formation of cracks in the photosensitive polymer layer, in particular on a printing surface of the printing plate, or tend to develop cracks in the photosensitive polymer layer after only a few printing cycles have been performed with the printing plate. Fig. 1 shows a photograph of a corresponding cured printing plate 10 having cracks 12 in the photosensitive polymer layer. A first portion 14 at the left side of the printing plate 10 has been covered with black ink which has been transferred to the printing surface of the printing plate 10, wherein a second portion 16 of the printing plate 10, shown at the right side of the printing plate 10, is not covered with black ink. As can be seen from the first portion 14, the cracks 12 are located at the printing surface of the printing plate 10.

Such cracks 12 as shown in Fig. 1 are disadvantageous because the quality of printed images is reduced in comparison to printed images obtained from printing plates without cracks. Moreover, it is desired to avoid the development of cracks in order to use a printing plate as long as possible thereby reducing the frequency for replacing the printing plate.

Accordingly, it is an objective of the present invention to provide a method and an apparatus for curing a printing plate allowing to avoid or at least to reduce the formation of cracks in the printing plate.

This objective is solved by the subject matter of the independent claims. Preferred embodiments are defined in the dependent claims.

A first aspect relates to a method for curing a printing plate comprising a photosensitive polymer layer sensitive to actinic radiation and an imaging layer covering the photosensitive polymer layer, the method comprising:
generating with a (first) radiation source a sequence of exposure cycles to expose the photosensitive polymer layer through the imaging layer to actinic radiation radiated from the radiation source,
wherein the sequence of exposure cycles comprises a first set of exposure cycles followed by a second set of exposure cycles, the first set of exposure cycles having a corresponding first set of intensities of the actinic radiation and the second set of exposure cycles having a corresponding second set of intensities of the actinic radiation,
wherein the intensity of the actinic radiation within the first set of intensities is lower than the intensity of the actinic radiation within the second set of intensities and/or an energy input to the photosensitive polymer layer by each exposure cycle of the first set of exposure cycles is lower than the energy input of each exposure cycle of the second set of exposure cycles,
wherein the second set of exposure cycles comprises equal or more exposure cycles than the first set of exposure cycles, and
wherein the energy input of the first set of exposure cycles is about 10% to 30% of the energy input of the sequence of exposure cycles.

Advantageously, by exposing the printing plate with the first set of exposure cycles before the second set of exposure cycles and having the specific energy input to the printing plate or photosensitive polymer layer, i.e., the energy input of the first set of exposure cycles is about 10% to 30% of the energy input of the sequence of exposure cycles, the printing plate or photosensitive polymer layer can be cured and the formation of cracks in the printing plate can be avoided.

Further, the first set of exposure cycles may comprise only one exposure cycle and/or the second set of exposure cycles may comprise only one exposure cycle. In a preferred embodiment, the first set of exposure cycles may comprise at least one exposure cycle and particularly preferably a plurality of exposure cycles and/or the second set of exposure cycles may comprise at least one exposure cycle and particularly preferably a plurality of exposure cycles.

Preferably, the sequence of exposure cycles may cure the printing plate or the photosensitive polymer layer such that printing features according to an image information transferred in the imaging layer are developed in the photosensitive polymer layer (see above). The printing features, which may consist of cured photosensitive polymer, may allow transferring a print medium, e.g., printing ink, to a substrate, e.g., packaging material, paper, etc., during a later printing process. Preferably, the sequence of exposure cycles may allow to develop printing features having a flat top shape, in the following referred to as flat top printing features.

Moreover, the sequence of exposure cycles may be the only exposure cycles applied through the imaging layer for curing the printing plate and developing the printing features. That is, no additional exposure cycles trough the imaging layer are required in addition to the sequence of exposure cycles for curing the printing plate. Further, it may be preferred that the sequence of exposure cycles may comprise only the first set of exposure cycles and the second set of exposure cycles.

Preferably, for curing the printing plate, one or more additional exposure cycles for exposing the photosensitive polymer layer with actinic radiation through a substrate layer of the printing plate may be provided. The substrate layer may be arranged opposite to the imaging layer with respect to the photosensitive polymer layer. That is, the photosensitive polymer layer may be provided between the substrate layer and the imaging layer. Further, the substrate layer may be at least partially permeable to actinic radiation. Preferably, the one or more additional exposure cycles for exposing the photosensitive polymer layer through the substrate layer with actinic radiation may be provided by a second radiation source. The second radiation source may be a distinct radiation source to the first radiation source. Moreover, the one or more additional exposure cycles for exposing the photosensitive polymer layer through the substrate layer with actinic radiation may be provided before, after or during the sequence of exposure cycles performed by the first radiation source. Exposing the photosensitive polymer layer with actinic radiation through the substrate layer advantageously cause the photosensitive polymer layer to develop a flooring on which the printing features rest/develop. Alternatively, the one or more additional exposure cycles for exposing the photosensitive polymer layer through the substrate layer with actinic radiation may be provided by the first radiation source. That is, the first radiation source is configured to provide the sequence of exposure cycles for exposing the photosensitive polymer layer through the imaging layer with actinic radiation and configured to provide the one or more additional exposure cycles for exposing the photosensitive polymer layer through the substrate layer with actinic radiation.

Further, each exposure cycle of the first set of exposure cycles may be performed with a corresponding intensity of the actinic radiation of the first set of intensities and/or each exposure cycle of the second set of exposure cycles may be performed with a corresponding intensity of the actinic radiation of the second set of intensities. It is to be noted that values of intensity of the actinic radiation given in this description refer to intensity values measured on the surface of the printing plate, i.e., a surface of the imaging layer or the substrate layer facing the respective radiation source radiating the actinic radiation. However, the intensity of the actinic radiation provided with each exposure cycle of the first set of exposure cycles is lower than the intensity of each exposure cycle of the second set of exposure cycles.

Further, it is to be noted that values of an energy input to the printing plate or to the photosensitive polymer layer given in this description refer to calculated values determined by the exposure time, i.e., the duration a specific portion is exposed with the exposure cycle, and the intensity the specific portion of the printing plate is exposed to the actinic radiation by the exposure cycle.

In a preferred embodiment, the second set of exposure cycles may comprise at least 1,5 times more exposure cycles than the first set of exposure cycles and/or the sequence of exposure cycles may comprise 7 to 17 (seven to seventeen exposure cycles). Accordingly, it is possible to gradually control or increase the energy input to the printing plate to control the curing of the printing plate and to avoid formation of cracks.

In a preferred embodiment, a respective first exposure time with which each exposure cycle of the first set of exposure cycles exposes an exposed portion of the printing plate with the actinic radiation is equal or higher than a second exposure time with which each exposure cycle of the second set of exposure cycles exposes the exposed portion of the printing plate with the actinic radiation, and wherein preferably the first exposure time is at least two times higher than the second exposure time. Accordingly, by reducing the exposure time for the second set of exposure cycles, the overall time for curing the printing plate can be reduced.

Further, the first exposure time and the first set of entities may by such that the energy input by each exposure cycle of the first set of exposure cycles is lower than the energy input by each exposure cycle of the second set of exposure cycles. Accordingly, the energy input can be gradually increased with each exposure cycle to avoid formation of cracks.

In a preferred embodiment, the intensity of the actinic radiation within the first set of intensities is less or equal than about 300 mW/cm² while the intensity of the actinic radiation within the second set of intensities is higher than about 1200 mW/cm², and wherein preferably the intensity of the actinic radiation within the first set of intensities is less or equal than about 100 mW/cm² while the intensity of the actinic radiation within the second set of intensities is higher than about 100 mW/cm². The given intensities have shown a significant reduction of formation of cracks in the printing plate.

In a preferred embodiment, the intensity of the actinic radiation within the second set of intensities is at least 5-times higher than the intensity of the actinic radiation within the first set of intensities. Advantageously, the energy input of each exposure cycle of the second set of exposure cycles has a higher energy input than each exposure cycle of the second set of exposure cycles. Accordingly, the energy input to the printing plate can be gradually controlled in order to avoid formation of cracks in the printing plate.

In a preferred embodiment, the intensity of the actinic radiation within the first set of intensities may be substantially constant and/or wherein the intensity of the actinic radiation within the second set of intensities may be substantially constant. Thus, the intensity of the actinic radiation used in the first set of exposure cycles and/or the intensity of the actinic radiation used in the second set of intensities can be maintained substantially constant which facilitates controlling of the intensities of the sequence of exposure cycles.

In a preferred embodiment, the first set of exposure cycles may comprise 5 exposure cycles having an intensity of about 40 mW/cm² to 60mW/cm², preferable of about 50 mW/cm², and the second set of exposure cycles may comprise 9 exposure cycles having an intensity of about 290 mW/cm² to 330 mW/cm², preferably of about 311 mW/cm². Alternatively, the first set of exposure cycles may comprise 3 exposure cycles having an intensity of about 40 mW/cm² to 60mW/cm², preferable of about 50 mW/cm², and the second set of exposure cycles may comprise 12 exposure cycles having an intensity of about 290 mW/cm² to 330 mW/cm², preferably of about 311 mW/cm². These embodiments may be suitable for curing a particular printing plate and avoiding the formation of cracks. In particular, the printing plate may be a printing plate which is certified to be cured by exposing the entire printing plate at the same time with actinic radiation, e.g., by a bank exposure device, wherein the intensity of the actinic radiation which is suitable for curing the printing plate and which causes flat top printing features is below about 30 mW/cm² and equal or higher than about 17 mW/cm². Preferably, the intensity of the actinic radiation which is suitable for curing the printing plate and which causes flat top printing features is below about 25mW/cm² and equal or higher than about 17 mW/cm². Preferably, the particular plate is a "nyloflex^{®} FTH 170 Digital" printing plate manufactured by Flint Group or a printing plate similar to the aforementioned plate. Further, it is expected that a "nyloflex^{®} FTH 114 Digital" printing plate also works as the particular plate.

Preferably, in the aforementioned embodiments, each exposure cycle of the first and second set of exposure cycles may expose a specific portion of the printing plate for a specific exposure time, i.e., duration, wherein the exposure time for each exposure cycle of the first set of exposure cycles may be such that the energy input to the specific portion by each exposure cycle of the first set of exposure cycles is about 400 mJ/cm² to 500 mJ/cm², and preferably about 465 mJ/cm². Further, the exposure time for each exposure cycle of the second set of exposure cycles may be such that the energy input to the specific portion by each exposure cycle of the second set of exposure cycles is about 975 mJ/cm² to 1075 mJ/cm², and preferably about 1026 mJ/cm². Moreover, the specific portion exposed by the radiation source may be the entire printing plate and the sequence of exposure cycles may be generated without interruptions between the exposure cycles or with periods of non-exposure, i.e., interruption, between consecutive exposure cycles. Alternatively, it is preferred that the radiation source may have a radiation field which may expose a portion of the printing plate with the actinic radiation only. Thus, the radiation source can be provided smaller and less expensive. To expose the entire printing plate with the radiation source having the radiation field which exposes only a portion of the printing plate, the entire printing plate may be exposed by providing relative movement between the radiation source and the printing plate (as will be explained further below).

In a preferred embodiment, the first set of exposure cycles may comprise four (4) exposure cycles having an intensity of about 40 mW/cm² to 60mW/cm², preferable of about 50 mW/cm², and the second set of exposure cycles may comprise 12 exposure cycles having an intensity of about 290 mW/cm² to 330 mW/cm², preferably of about 311 mW/cm². Preferably, each exposure cycle of the first and second set of exposure cycles may expose a specific portion of the printing plate for a specific exposure time, i.e., duration, wherein the exposure time for each exposure cycle of the first set of exposure cycles may be such that the energy input to the specific portion by each exposure cycle of the first set of exposure cycles is about 325 mJ/cm² to 425 mJ/cm², and preferably about 475 mJ/cm². Further, the exposure time for each exposure cycle of the second set of exposure cycles may be such that the energy input to the specific portion by each exposure cycle of the second set of exposure cycles is about 883 mJ/cm² to 983 mJ/cm², and preferably about 933 mJ/cm². As discussed above, the specific portion exposed by the radiation source may be the entire printing plate and the sequence of exposure cycles may be generated without interruptions between the exposure cycles or with periods of non-exposure, i.e., interruptions, between consecutive exposure cycles. Alternatively, it is preferred that the radiation source may have a radiation field which may expose a portion of the printing plate with the actinic radiation. Thus, the radiation source can be provided smaller and less expensive. To expose the entire printing plate with the radiation source having the radiation field which exposes only a portion of the printing plate, the entire printing plate may be exposed by providing relative movement between the radiation source and the printing plate (as will be explained further below). This embodiment may be suitable for curing a particular printing plate and avoiding the formation of cracks. In particular, the printing plate may be a printing plate which is certified to be cured by exposing the entire printing plate at the same time with actinic radiation, e.g., by a bank exposure device, wherein the intensity of the actinic radiation which is suitable for curing the printing plate and which causes flat top printing features is below about 30 mW/cm² and equal or higher than about 18 mW/cm². Preferably, the intensity of the actinic radiation which is suitable for curing the printing plate and which causes flat top printing features is about 20 mW/cm² to 24 mW/cm². Preferably, the particular plate is a "nyloflex^{®} FTS 170 Digital" printing plate manufactured by Flint Group or a printing plate similar to the aforementioned plates. Further, it is expected that a "nyloflex^{®} FTS 114 Digital" printing plate manufactured by Flint Group also works as the particular plate.

Alternatively, the first set of exposure cycles may comprise 2 (two) exposure cycles having an intensity of about 40 mW/cm² to 60mW/cm², preferable of about 50 mW/cm², and the second set of exposure cycles may comprise 6 (six) exposure cycles having an intensity of about 290 mW/cm² to 330 mW/cm², preferably of about 311 mW/cm². Preferably, each exposure cycle of the first and second set of exposure cycles may expose a specific portion of the printing plate for a specific exposure time, i.e., duration, wherein the exposure time for each exposure cycle of the first set of exposure cycles may be such that the energy input to the specific portion by each exposure cycle of the first set of exposure cycles is about 775 mJ/cm² to 875 mJ/cm², and preferably about 825 mJ/cm². Further, the exposure time for each exposure cycle of the second set of exposure cycles may be such that the energy input to the specific portion by each exposure cycle of the second set of exposure cycles is about 2282 mJ/cm² to 2382 mJ/cm², and preferably about 2332 mJ/cm². As discussed above, the specific portion exposed by the radiation source may be the entire printing plate and the sequence of exposure cycles may be generated without interruptions between the exposure cycles or with periods of non-exposure, i.e., interruption, between consecutive exposure cycles. Alternatively, it is preferred that the radiation source may have a radiation field which may expose a portion of the printing plate with the actinic radiation. Thus, the radiation source can be provided smaller and less expensive. To expose the entire printing plate with the radiation source having the radiation field which exposes only a portion of the printing plate, the entire printing plate may be exposed by providing relative movement between the radiation source and the printing plate (as will be explained further below). This embodiment may be suitable for curing a particular printing plate and avoiding the formation of cracks. In particular, the printing plate may be a printing plate which is certified to be cured by exposing the entire printing plate at the same time with actinic radiation, e.g., by a bank exposure device, wherein the intensity of the actinic radiation which is suitable for curing the printing plate and which causes flat top printing features is below about 30 mW/cm² and equal or higher than about 18 mW/cm². Preferably, the intensity of the actinic radiation which is suitable for curing the printing plate and which causes flat top printing features is about 20 mW/cm² to 24 mW/cm². Preferably, the particular plate is a "nyloflex^{®} FTS 170 Digital" printing plate manufactured by Flint Group or a printing plate similar to the aforementioned plates. Further, it is expected that a "nyloflex^{®} FTS 114 Digital" printing plate manufactured by Flint Group also works as the particular plate.

Preferably, the actinic radiation is ultraviolet, UV, light radiation with a preferred wavelength of about 350 to 400 nm. More preferably, the wavelength is in the range of about 360 to 370 nm with a highest intensity at about 365 nm. Further, the radiation source may comprise at least one UV-Light Emitting Diode (LED). Preferably, the radiation source may comprise a plurality of UV-LEDs which may be arranged in an array form so that the radiation field of the radiation source is uniformly exposed/illuminated. The use of UV-LEDs is advantageous because of their low failure rate and long lifetime. Moreover, the intensity of the UV-LEDs can be easily controlled as compared to UV-light bulbs or fluorescent tubes. Further, the energy consumption and warmup time of UV-LEDs is lower compared to UV-light bulbs or UV fluorescent tubes. Preferably, the radiation source comprises UV-LEDs only.

In a preferred embodiment, the sequence of exposure cycles may comprise providing relative motion between the radiation source and the printing plate. As explained above, the radiation source may have a radiation field which may expose only a portion of the printing plate with the actinic radiation, i.e. the size of the radiation field is only a fraction of the size of the printing plate. Accordingly, by providing relative motion between the radiation source and the printing plate, the radiation field may scan the entire printing plate. For example, the printing plate may be supported by a support member on which the printing plate is arranged flat and the radiation source may be moved relative to the printing plate several times to generate the sequence of exposure cycles.

Alternatively, the printing plate may be arranged or fixed around a tubular cylindrical support member which rotates around its cylinder axis and the radiation source is fixedly arranged with respect to the tubular support.

A second aspect relates to an apparatus for curing a printing plate comprising a photosensitive polymer layer sensitive to actinic radiation and an imaging layer covering the photosensitive polymer layer, the apparatus comprising:
a support member configured to support the printing plate;
a (first) radiation source configured to radiate actinic radiation; and
a control unit configured to generate a sequence of exposure cycles in which the radiation source exposes the photosensitive polymer layer through the imaging layer to the actinic radiation,
wherein the sequence of exposure cycles comprises a first set of exposure cycles followed by a second set of exposure cycles, the first set of exposure cycles having a corresponding first set of intensities of the actinic radiation and the second set of exposure cycles having a corresponding second set of intensities of the actinic radiation,
wherein the intensity of the actinic radiation within the first set of intensities is lower than the intensity of the actinic radiation within the second set of intensities and/or an energy input to the photosensitive polymer layer by each exposure cycle of the first set of exposure cycles is lower than the energy input of each exposure cycle of the second set of exposure cycles,
wherein the second set of exposure cycles comprises equal or more exposure cycles than the first set of exposure cycles, and
wherein the energy input of the first set of exposure cycles is about 10% to 30% of the energy input of the sequence of exposure cycles.

Preferably, the apparatus of the second aspect may support the method for curing the printing plate according to the first aspect.

In a preferred embodiment, the radiation source may comprise a UV-LED as a radiation source providing UV-light as the actinic radiation. Preferably, the radiation source may comprise a plurality of UV-LEDs which may be arranged in an array form so that a radiation field of the radiation source with which the printing plate is exposed is uniformly exposed/illuminated. The use of UV-LEDs is advantageous because of their low failure rate. Moreover, the intensity of the UV-LEDs can be easily controlled as compared to UV-light bulbs or fluorescent tubes. Further, the energy consumption of UV-LEDs is lower as compared to UV-light bulbs or fluorescent tubes. Preferably, the radiation source comprises UV-LEDs only.

In a preferred embodiment, the control unit is configured to apply pulse width modulation (PWM) to a control signal controlling the intensity of the UV-LED radiation source. For example, the control signal may have a frequency of about 2 kHz. Using PWM for controlling the intensity of the UV-LEDs is advantageous, because the intensity of the UV-LEDs can be controlled more precisely as compared to controlling the supply voltage/current of the UV-LEDs.

In a preferred embodiment, the apparatus may be further configured to generate the sequence of exposure cycles by providing relative motion between the radiation source and the printing plate. As explained above for the first aspect, the radiation source may have a radiation field which may expose only a portion of the printing plate with the actinic radiation, i.e. the size of the radiation field is only a fraction of the size of the printing plate. Accordingly, by providing relative motion between the radiation source and the printing plate, the radiation field may scan the entire printing plate. For example, the printing plate may be supported by the support member on which the printing plate is arranged in a flat manner and the radiation source may be moved relative to the printing plate several times to generate the sequence of exposure cycles. In particular, the radiation source may be provided as a bar having a plurality of UV-LEDs arranged in an array form, wherein the longitudinal direction of the radiation field caused by the radiation source covers the length or the width of the printing plate. Further, the bar may be moved relative to the plate, in particular along the longitudinal direction or width direction of the printing plate to generate the sequence of exposure cycles.

In a preferred embodiment, the support member may be provided as a flatbed on which the printing plate can be positioned. The radiation source may be provided above the printing plate such that the imaging layer faces the radiation source. The apparatus may further comprise a driver member configured to move the radiation source relative to the support member or the printing plate.

Alternatively, the support member may have a tubular or cylindrical form and the printing plate may be arranged or fixed around the support member. Further, the radiation source may be fixedly arranged with respect to the support member and the radiation field of the radiation source may cover the longitudinal direction of the support member to expose the printing plate over its whole width to actinic radiation at the same time. The width of the printing plate may correspond to the longitudinal direction of the support member.

Preferably, the apparatus may comprise a second radiation source configured to generate one or more additional exposure cycles for exposing the photosensitive polymer layer with actinic radiation through a substrate layer of the printing plate. The second radiation source may be a different radiation source to the first radiation source. Exposing the photosensitive polymer layer with actinic radiation through the substrate layer advantageously cause the photosensitive polymer layer to develop a flooring on which the printing features rest/develop.

A third aspect relates to a computer-readable medium comprising computer-readable instructions which, when loaded and executed by an apparatus for curing a printing plate comprising a photosensitive polymer layer sensitive to actinic radiation and an imaging layer covering the photosensitive polymer layer, cause the apparatus for curing the printing plate to:
generate with a radiation source a sequence of exposure cycles to expose the photosensitive polymer layer through the imaging layer to actinic radiation radiated from the radiation source,
wherein the sequence of exposure cycles comprises a first set of exposure cycles followed by a second set of exposure cycles, the first set of exposure cycles having a corresponding first set of intensities of the actinic radiation and the second set of exposure cycles having a corresponding second set of intensities of the actinic radiation,
wherein the intensity of the actinic radiation within the first set of intensities is lower than the intensity of the actinic radiation within the second set of intensities and/or an energy input to the photosensitive polymer layer by each exposure cycle of the first set of exposure cycles is lower than the energy input of each exposure cycle of the second set of exposure cycles,
wherein the second set of exposure cycles comprises equal or more exposure cycles than the first set of exposure cycles, and
wherein the energy input of the first set of exposure cycles is about 10% to 30% of the energy input of the sequence of exposure cycles.

Preferably, the computer-readable medium may comprise further instructions allowing the apparatus to perform the method according to the first aspect.

A fourth aspect related to a parameter set comprising exposure parameters for curing a printing plate comprising a photosensitive polymer layer sensitive to actinic radiation and an imaging layer covering the photosensitive polymer layer which, when loaded into an apparatus for curing the printing plate, causes the apparatus for curing the printing plate to:
generate with a radiation source a sequence of exposure cycles to expose the photosensitive polymer layer through the imaging layer to actinic radiation radiated from the radiation source,
wherein the sequence of exposure cycles comprises a first set of exposure cycles followed by a second set of exposure cycles, the first set of exposure cycles having a corresponding first set of intensities of the actinic radiation and the second set of exposure cycles having a corresponding second set of intensities of the actinic radiation,
wherein the intensity of the actinic radiation within the first set of intensities is lower than the intensity of the actinic radiation within the second set of intensities and/or an energy input to photosensitive polymer layer by each exposure cycle of the first set of exposure cycles is lower than the energy input of each exposure cycle of the second set of exposure cycles,
wherein the second set of exposure cycles comprises equal or more exposure cycles than the first set of exposure cycles, and
wherein the energy input of the first set of exposure cycles is about 10% to 30% of the energy input of the sequence of exposure cycles.

Preferably, the parameter set may comprise further parameters allowing the apparatus to perform the method according to the first aspect.

A fifth aspect relates to a method for curing a printing plate comprising a photosensitive polymer layer sensitive to actinic radiation and an imaging layer covering the photosensitive polymer layer, the method comprising:
generating, with a (first) radiation source capable of exposing the entire printing plate at the same time with actinic radiation, an exposure cycle to expose the photosensitive polymer layer through the imaging layer to the actinic radiation,
wherein the exposure cycle comprises at least a first phase and a second phase having a first duration and a second duration, respectively,
wherein a first intensity of the actinic radiation during the first phase is lower than a second intensity of the actinic radiation during the second phase, and
wherein an energy input to the photosensitive polymer layer during the first phase is about 10% to 30% of the energy input of the exposure cycle; or
wherein the intensity of the actinic radiation is at least partially increased over the duration of the exposure cycle and wherein the energy input to the photosensitive polymer layer caused by the exposure cycle cures the printing plate.

The first alternative of the method according to the fifth aspect is similar to the method of the first aspect in that the first phase may correspond to the first set of exposure cycles and the second phase may correspond to the second set of exposure cycles. Accordingly, the first phase may comprise the first set of exposure cycles which are generated consecutively. Further, the exposure cycles of the first set of exposure cycles may be generated without interruptions between the exposure cycles or with periods of non-exposure, i.e., interruption, between consecutive exposure cycles. Further, the second phase may comprise the second set of exposure cycles which are generated consecutively. Further, the exposure cycles of the second set of exposure cycles may be generated without interruptions between the exposure cycles or with periods of non-exposure, i.e., interruption, between consecutive exposure cycles.

In the second alternative of the fifth aspect, the intensity at the beginning of the exposure cycle may have a lower intensity than at the end of the exposure cycle. In a preferred embodiment, the intensity of the actinic radiation may be kept constant for a first exposure time, i.e., a first duration, and is at least partially increased during a second exposure time subsequent to the first exposure time. Advantageously, by increasing the intensity gradually over the duration of the exposure cycle, the formation of cracks in the printing plate can be avoided. Further, it is preferable that the exposure cycle is the only exposure cycle provided through the imaging layer for curing the printing plate. However, one or more additional exposure cycles through the substrate layer, as discussed with respect to the above aspects, are possible.

Preferably, for curing the printing plate, one or more additional exposure cycles for exposing the photosensitive polymer layer with actinic radiation through a substrate layer of the printing plate may be provided. The substrate layer may be arranged opposite to the imaging layer with respect to the photosensitive polymer layer. That is, the photosensitive polymer layer may be provided between the substrate layer and the imaging layer. Further, the substrate layer may be at least partially permeable to actinic radiation. Preferably, the one or more additional exposure cycles for exposing the photosensitive polymer layer through the substrate layer with actinic radiation may be provided by a second radiation source which is preferably a different radiation source to the first radiation source. Moreover, the one or more additional exposure cycles for exposing the photosensitive polymer layer through the substrate layer with actinic radiation may be provided before, after or during the sequence of exposure cycles performed by the first radiation source. Exposing the photosensitive polymer layer with actinic radiation through the substrate layer advantageously cause the photosensitive polymer layer to develop a flooring on which the printing features rest/develop.

A sixth aspect relates to an apparatus for curing a printing plate comprising a photosensitive polymer layer sensitive to actinic radiation and an imaging layer covering the photosensitive polymer layer, the apparatus comprising:
a support member configured to support the printing plate;
a (first) radiation source configured to expose the entire printing plate at the same time to actinic radiation; and
a control unit configured to generate an exposure cycle in which the radiation source exposes the photosensitive polymer layer through the imaging layer to the actinic radiation,
wherein the exposure cycle comprises at least a first phase and a second phase having a first duration and second duration, respectively,
wherein a first intensity of the actinic radiation during the first phase is lower than a second intensity of the actinic radiation during the second phase, and
wherein an energy input to the photosensitive polymer layer during the first phase is about 10% to 30% of the energy input of the exposure cycle; or
wherein the intensity of the actinic radiation is at least partially increased over the duration of the exposure cycle and wherein the energy input to the photosensitive polymer layer caused by the exposure cycle cures the printing plate.

Preferably, the apparatus of the sixth aspect may support the method for curing the printing plate according to the fifth aspect.

Preferably, the radiation source may have a radiation field which can cover the entire printing plate with actinic radiation. Further, the radiation source may comprise a plurality of UV-LEDS configured to uniformly illuminate/expose the radiation field with actinic radiation.

Preferably, the apparatus may comprise a second radiation source configured to generate one or more additional exposure cycles for exposing the photosensitive polymer layer with actinic radiation through a substrate layer of the printing plate. The second radiation source may be a different radiation source to the first radiation source. Exposing the photosensitive polymer layer with actinic radiation through the substrate layer advantageously cause the photosensitive polymer layer to develop a flooring on which the printing features rest/develop.

A seventh aspect relates to a computer-readable medium comprising computer-readable instructions which, when loaded and executed by an apparatus for curing a printing plate comprising a photosensitive polymer layer sensitive to actinic radiation and an imaging layer covering the photosensitive polymer layer, cause the apparatus for curing the printing plate to:
generate, with a radiation source capable of exposing the entire printing plate at the same time with actinic radiation, an exposure cycle in which the radiation source exposes the photosensitive polymer layer through the imaging layer to the actinic radiation,
wherein the exposure cycle comprises at least a first phase and a second phase having a first duration and second duration, respectively,
wherein a first intensity of the actinic radiation during the first phase is lower than a second intensity of the actinic radiation during the second phase, and
wherein an energy input to the photosensitive polymer layer during the first phase is about 10% to 30% of the energy input of the exposure cycle; or
wherein the intensity of the actinic radiation is at least partially increased over the duration of the exposure cycle and wherein the energy input to the photosensitive polymer layer caused by the exposure cycle cures the printing plate.

Preferably, the computer-readable medium may comprise further instructions allowing the apparatus to perform the method according to the fifth aspect.

An eighth aspect relates to a parameter set comprising exposure parameters for curing a printing plate comprising a photosensitive polymer layer sensitive to actinic radiation and an imaging layer covering the photosensitive polymer layer which, when loaded into an apparatus for curing the printing plate, causes the apparatus for curing the printing plate to:
generate, with a radiation source capable of exposing the entire printing plate at the same time with actinic radiation, an exposure cycle in which the radiation source exposes the photosensitive polymer layer through the imaging layer to the actinic radiation,
wherein the exposure cycle comprises at least a first phase and a second phase having a first duration and second duration, respectively,
wherein a first intensity of the actinic radiation during the first phase is lower than a second intensity of the actinic radiation during the second phase, and
wherein an energy input to the photosensitive polymer layer during the first phase is about 10% to 30% of the energy input of the exposure cycle; or
wherein the intensity of the actinic radiation is at least partially increased over the duration of the exposure cycle and wherein the energy input to the photosensitive polymer layer caused by the exposure cycle cures the printing plate.

Preferably, the parameter set may comprise further parameters allowing the apparatus to perform the method according to the fifth aspect.

A ninth aspect relates to a cured printing plate produced by a method according to the first or fifth aspect, wherein the printing plate is a printing plate which is certified for curing by exposing the entire printing plate at the same time with actinic radiation so as to produce preferably flat top printing features without cracks in a printing surface of a photosensitive polymer layer of the printing plate.

A tenth aspect relates to a method comprising:
providing a parameter set according to the fourth or eighth aspect;
loading the parameter set into an apparatus for curing a printing plate; and
controlling a curing process of a printing plate performed with the apparatus at least partially based on the parameter set.

These and other objects, features and advantages of the present invention will become more apparent upon reading of the following detailed description of preferred embodiments and accompanying drawings. It should be understood that even though embodiments are separately described, single features thereof may be combined to additional embodiments.
- Figure 1: shows a printing plate with a formation of cracks on a printing surface of the printing plate,
- Figure 2: shows a process for preparing a printing plate,
- Figure 3: shows the basic structure of a printing plate
- Figure 4: shows a printing feature of the printing plate,
- Figure 5: shows a first configuration of an apparatus for curing a printing plate,
- Figure 6: shows a second configuration of an apparatus for curing a printing plate,
- Figure 7: shows a third configuration of an apparatus for curing a printing plate,
- Figure 8: shows a first table with parameters for curing a printing plate,
- Figure 9: shows a second table with parameters for curing a printing plate, and
- Figure 10: shows an improvement achieved by the present invention.

Figure 1 shows a photograph of a printing plate 10 comprising a photosensitive polymer layer. The printing plate 10 was cured by exposing the printing plate or the photosensitive polymer layer to actinic radiation, e.g., ultraviolet (UV) radiation or light. As shown in Figure 1, the printing plate 10 comprises cracks 12 in the printing surface of the printing plate 10. A first portion 14 at the left side of the printing plate 10 has been covered with black ink to highlight cracks 12, wherein a second portion 16 of the printing plate 10, shown at the right side of the printing plate 10, is not covered with black ink. As can be seen from the first portion 14, the cracks 12 are located at the printing surface of the printing plate 10. It has been observed that printing plates tend to formation of cracks if the printing plate 10 or the photosensitive polymer layer is incorrectly exposed to actinic radiation. Moreover, cracks 12 in the printing plate 10 should be avoided because the quality of printed images printed with the printing plate 10 is reduced.

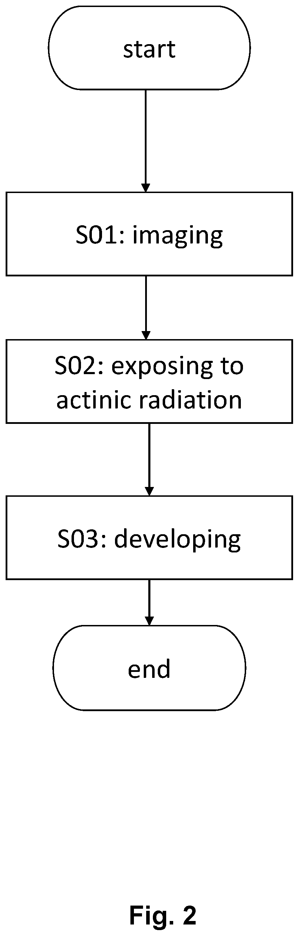

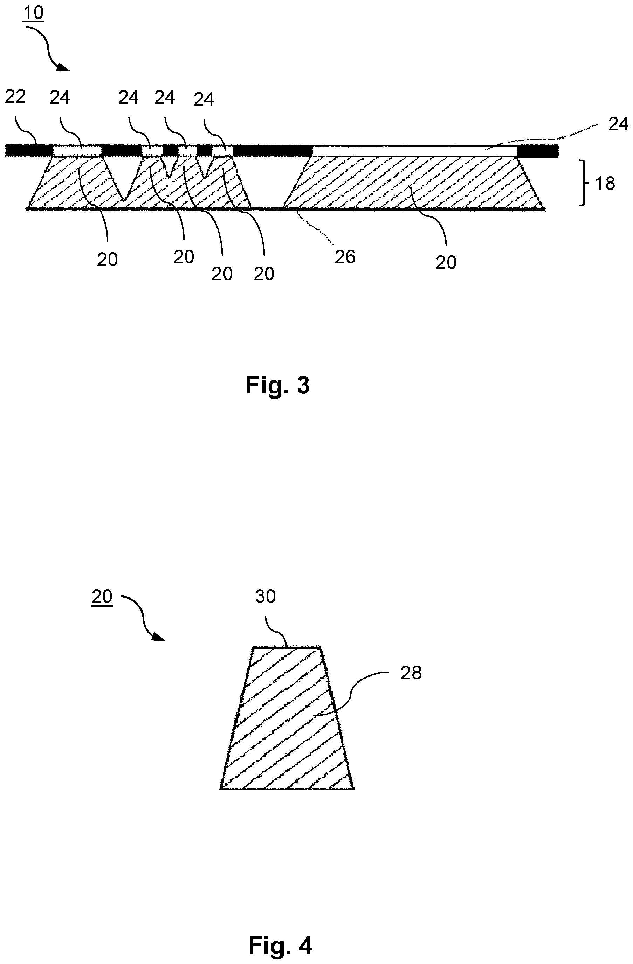

A general process for preparing a printing plate 10 so that images can be printed with the printing plate is discussed with reference to figures 2 and 3. At the start, an uncured printing plate 10 is provided. Figure 3 shows an already cured printing plate 10, however the structure may be similar to an uncured printing plate 10. The printing plate 10, such as a photopolymer flexographic plate and a letterpress printing plate, comprises a photosensitive polymer layer 18, which is sensitive to actinic radiation.

That is, actinic radiation will polymerize the photosensitive polymer layer 18 to cure the printing plate 10.

Before the printing plate 10 is cured, an imaging step S01 is performed. In the imaging step S01, image information is transferred to the printing plate 10. The transferred image information determines, where printing features 20 are developed at the printing plate 10, wherein the printing features 20 transfer a print medium, e.g., printing ink, to a substrate, e.g., packaging material, paper, etc., during a later printing process.

One possibility of transferring the image information during the imaging step S01 to the printing plate 10 is to transfer the image information to an imaging layer 22 covering the photosensitive polymer layer 18. For example, the imaging layer 22 may be impermeable to the actinic radiation which is used to cure the photosensitive polymer layer 18 of the printing plate 12 during a curing or exposing step S02 subsequent to the imaging step S01. To transfer the image information to the imaging layer 22, the imaging layer 22, e.g., made of a carbon material, may at least be partially ablated according to the image information, e.g., by using a laser. Accordingly, the image layer 22 may have ablated portions 24 according to the image information allowing actinic radiation to pass to the photosensitive polymer layer 18.

In the curing or exposing step S02 subsequent to the imaging step S01, the printing plate is exposed to actinic radiation through the imaging layer 22 to cure the photosensitive polymer layer 18, wherein printing features 20 develop are developed in the photosensitive polymer layer 18 according to the image information in the imaging layer 22.

Optionally, the exposing step S02 may comprise exposing the printing plate 10 to actinic radiation through a substrate layer 26 of the printing plate 10. The substrate layer 26 may be arranged opposite to the imaging layer 22 with respect to the photosensitive polymer layer 26. That is, the photosensitive polymer layer 18 may be provided between the substrate layer 26 and the imaging layer 22. Further, the substrate layer 26 may be at least partially permeable to actinic radiation.

After the exposing step S02, the printing plate usually undergoes a developing step S03 in which non-cured areas of the photosensitive polymer layer 18 and/or the imaging layer 22 are removed, e.g., by thermal development and/or by washing the non-cured areas of the photosensitive polymer layer 18 and the imaging layer 22 with a solvent, e.g., an organic or inorganic solvent. The printing plate 10 prepared by the process according to figure 2 may be used for a later printing process.

Figure 4 shows a detailed view of a printing feature 20 developed in the printing plate 10. In particular, figure 4 shows a printing feature 20 called flat top printing feature. It is preferred to have flat top printing features 20 because of a good and precise ink transfer to the to be printed medium. Flat top printing features 20 are characterized by having a substantially conical body 28 with a flat top surface 30 arranged at the narrower end of the conical body 28. The flat top surface 30 may allow the transfer of the print medium, e.g, ink, and extends substantially parallel to the imaging layer 22.

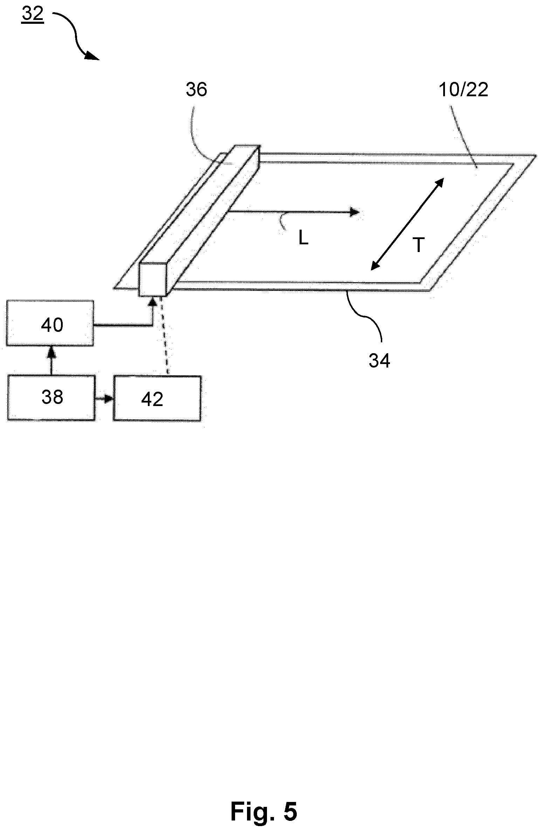

Figure 5 shows a first configuration of an apparatus 32 for curing a printing plate 10. The apparatus 32 may comprise a support member 34 configured to support the printing plate 10. As shown in figure 5, the support member 34 may be configured as a flatbed arrangement on which the printing plate 10 can be positioned in a flat manner. In particular, the printing plate 10 may be positioned such that the imaging layer 22 faces away from the support member 34 towards a radiation source 36. Thus, the radiation source 36 may expose the photosensitive polymer layer 18 with actinic radiation through the imaging layer 22.

Further, the apparatus 32 may comprise a control unit 38 configured to generate a sequence of exposure cycles in which the radiation source 36 exposes the photosensitive polymer layer 18 through the imaging layer 22 to the actinic radiation. Further, the control unit 38 may be configured to control the intensity of the actinic radiation radiated from the radiation source 36. For example, the control unit 38 may control a pulse width modulation unit 40 for generating a pulse width modulated control signal provided to the radiation source 36 for controlling the intensity of the actinic radiation.

Moreover, the radiation source 36 may have a radiation field whose size is smaller than the size of the printing plate 10. Accordingly, the radiation source 36 can expose only a portion of the printing plate 10 to actinic radiation at the same time. For exposing the entire printing plate 10 to actinic radiation, the apparatus is configured to provided relative movement between the radiation source 36 and the printing plate 10 or support member 34. For example, the radiation source 36 may move relative to the support member 34 or vice versa in order that the radiation source 36 can scan/expose the entire printing plate 10 with actinic radiation.

In the first configuration shown in figure 5, the apparatus may have a drive unit 42 configured to move the radiation source 36 along a longitudinal direction L of the support member 34 of the printing plate 10. Moreover, the radiation source 36 may be sized such that the radiation field fully covers the transverse direction T (direction perpendicular to the longitudinal direction L and parallel to the printing plate 10) of the printing plate 10. Accordingly, by moving the radiation source 36 along the longitudinal direction L, the entire printing plate 10 can be exposed to actinic radiation radiated from the radiation source 36.

In a preferred embodiment, the apparatus 32 may have a second radiation source (not shown) configured to expose the printing plate 10 to actinic radiation through the substrate layer 26 as discussed above. The second radiation source can be arranged opposite to the imaging layer 22 with respect to the photosensitive polymer layer 18. Further, the control unit 38 may be configured to generate a sequence of exposure cycles in which the radiation source 36 exposes the photosensitive polymer layer 18 through the imaging layer 22 to the actinic radiation. The sequence of exposure cycles may comprise a first set of exposure cycles followed by a second set of exposure cycles, the first set of exposure cycles having a corresponding first set of intensities of the actinic radiation and the second set of exposure cycles having a corresponding second set of intensities of the actinic radiation. Further, wherein the intensity of the actinic radiation within the first set of intensities is lower than the intensity of the actinic radiation within the second set of intensities and/or an energy input to the photosensitive polymer layer 18 by each exposure cycle of the first set of exposure cycles is lower than the energy input of each exposure cycle of the second set of exposure cycles, wherein the second set of exposure cycles comprises equal or more exposure cycles than the first set of exposure cycles, and wherein the energy input of the first set of exposure cycles is about 10% to 30% of the energy input of the sequence of exposure cycles. Moreover, each exposure cycle of the sequence of exposure cycles may by generated by moving/passing the radiation source 36 along the longitudinal direction L of the printing plate 10, i.e., one pass for each cycle.

Moreover, the radiation source 36 may comprise a plurality of UV-LEDs which may be arranged in an array form causing a uniform intensity distribution of the actinic radiation on the printing plate 10.

In a preferred configuration, the second set of exposure cycles may comprise at least 1,5 times more exposure cycles than the first set of exposure cycles and/or the sequence of exposure cycles may comprise 7 to 17 exposure cycles.

In a preferred configuration, a respective first exposure time with which each exposure cycle of the first set of exposure cycles exposes an exposed portion of the printing plate with the actinic radiation is equal or higher than a second exposure time with which each exposure cycle of the second set of exposure cycles exposes the exposed portion of the printing plate with the actinic radiation, and preferably, the first exposure time is at least two times higher than the second exposure time.

In a preferred embodiment, the control unit 38 controls the intensity of the actinic radiation within the second set of intensities such that the intensity is at least 5-times higher than the intensity of the actinic radiation within the first set of intensities, and/or the intensity of the actinic radiation within the first set of intensities is substantially constant and/or the intensity of the actinic radiation within the second set of intensities is substantially constant.

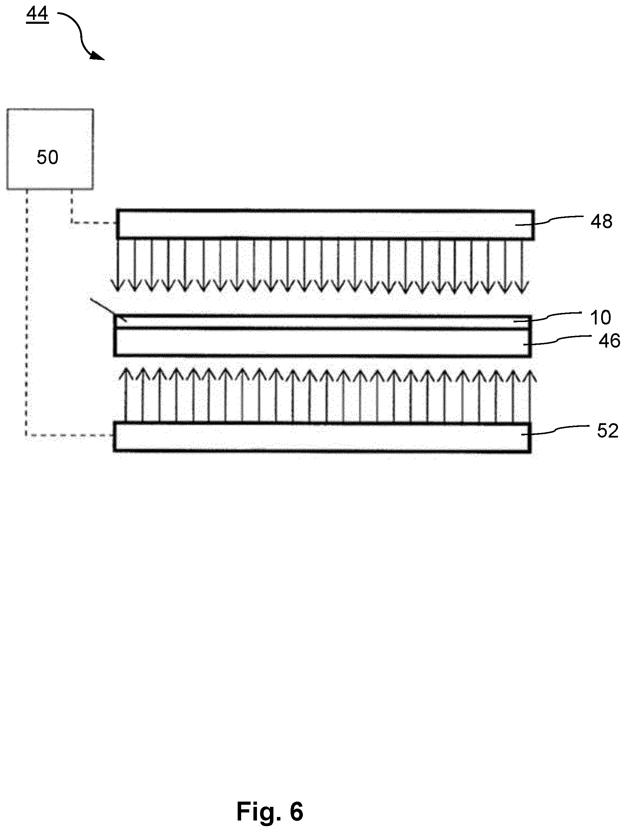

Figure 6 shows a second configuration of an apparatus 44 for curing a printing plate 10. The apparatus 44 may comprise a support member 46 configured to support the printing plate 10. As shown in figure 6, the support member 46 may be configured as a flatbed arrangement on which the printing plate 10 can be positioned in a flat manner. In particular, the printing plate 10 may be positioned such that the imaging layer 22 faces away from the support member 46 towards a first radiation source 48. Thus, the first radiation source 48 may expose the photosensitive polymer layer 18 with actinic radiation through the imaging layer 22.

Further, the apparatus 44 may comprise a control unit 50 configured to generate a sequence of exposure cycles in which the first radiation source 48 exposes the photosensitive polymer layer 18 through the imaging layer 22 to the actinic radiation. Further, the control unit 50 may be configured to control the intensity of the actinic radiation radiated from the first radiation source 48 by providing a pulse width modulated control signal to the first radiation source 48.

Moreover, the radiation source 48 may have a radiation field which allows to expose the entire printing plate with actinic radiation at the same time. Thus, the size of the radiation field has at least the same size as the printing plate 10.

In a preferred embodiment, the apparatus 44 may have a second radiation source 52 configured to expose the printing plate 10 to actinic radiation through the substrate layer 26 as discussed above. The second radiation source 52 can be arranged opposite to the imaging layer 22 with respect to the photosensitive polymer layer 18.

Further, the control unit 50 may be configured to generate a sequence of exposure cycles in which the first radiation source 48 exposes the photosensitive polymer layer 18 through the imaging layer 22 to the actinic radiation. The sequence of exposure cycles may comprise a first set of exposure cycles followed by a second set of exposure cycles, the first set of exposure cycles having a corresponding first set of intensities of the actinic radiation and the second set of exposure cycles having a corresponding second set of intensities of the actinic radiation. Further, wherein the intensity of the actinic radiation within the first set of intensities is lower than the intensity of the actinic radiation within the second set of intensities and/or an energy input to the photosensitive polymer layer 18 by each exposure cycle of the first set of exposure cycles is lower than the energy input of each exposure cycle of the second set of exposure cycles, wherein the second set of exposure cycles comprises equal or more exposure cycles than the first set of exposure cycles, and wherein the energy input of the first set of exposure cycles is about 10% to 30% of the energy input of the sequence of exposure cycles.

Moreover, the first radiation source 48 may comprise a plurality of UV-LEDs which may be arranged in an array form causing a uniform intensity distribution of the actinic radiation on the printing plate 10.

In a preferred configuration, the second set of exposure cycles may comprise at least 1,5 times more exposure cycles than the first set of exposure cycles and/or the sequence of exposure cycles may comprise 7 to 17 exposure cycles.

In a preferred configuration, a respective first exposure time with which each exposure cycle of the first set of exposure cycles exposes an exposed portion of the printing plate with the actinic radiation is equal or higher than a second exposure time with which each exposure cycle of the second set of exposure cycles exposes the exposed portion of the printing plate with the actinic radiation, and preferably, the first exposure time is at least two times higher than the second exposure time.

In a preferred embodiment, the control unit 50 controls the intensity of the actinic radiation within the second set of intensities such that the intensity is at least 5-times higher than the intensity of the actinic radiation within the first set of intensities, and/or the intensity of the actinic radiation within the first set of intensities is substantially constant and/or the intensity of the actinic radiation within the second set of intensities is substantially constant.

Moreover, the sequence of exposure cycles may be generated without interruptions between the exposure cycles or with periods of non-exposure, i.e., interruption, between consecutive exposure cycles.

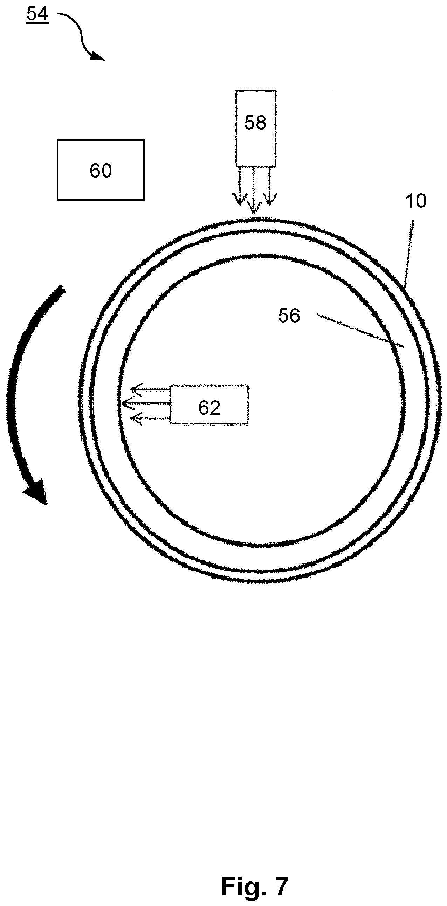

Figure 7 shows a third configuration of an apparatus 54 for curing a printing plate 10. The apparatus 54 may comprise a support member 56 configured to support the printing plate 10. As shown in figure 7, the support member 56 may have a tubular or cylindrical form/shape. The printing plate 10 may be attachable to the outer circumference of the support member 56. In particular, the printing plate 10 may be positioned such that the imaging layer 22 faces away from the support member 56 towards a first radiation source 58 which is fixedly installed with respect to the support member 56. Thus, the first radiation source 56 may expose the photosensitive polymer layer 18 with actinic radiation through the imaging layer 22.

Further, the apparatus 54 may comprise a control unit 60 configured to generate a sequence of exposure cycles in which the first radiation source 58 exposes the photosensitive polymer layer 18 through the imaging layer 22 to the actinic radiation. Further, a control unit 60 may be configured to control the intensity of the actinic radiation radiated from the first radiation source 58. For example, the control unit 60 may control a pulse width modulation unit (not shown) for generating a pulse width modulated control signal provided to the first radiation source 58 for controlling the intensity of the actinic radiation.

Moreover, the first radiation source 58 may have a radiation field whose size is smaller than the size of the printing plate 10. Accordingly, the first radiation source 58 can expose only a portion of the printing plate 10 to actinic radiation at the same time. For exposing the entire printing plate 10 to actinic radiation, the apparatus 54 is configured to provided relative movement between the first radiation source 58 and the printing plate 10 or support member 56. In particular, the apparatus 54 may be configured to rotate the tubular or cylindrical formed support member 56 around its cylinder axis, thereby providing relative motion between the printing plate 10 and the first radiation source 58. Moreover, the first radiation source 58 may be sized such that the radiation field fully covers the printing plate along the direction of the cylinder axis of the support member 56.

In a preferred embodiment, the apparatus 54 may have a second radiation source 62 configured to expose the printing plate 10 to actinic radiation through the substrate layer 26 as discussed above. The second radiation source 62 may be arranged opposite to the imaging layer 22 with respect to the photosensitive polymer layer 18. For example, the second radiation source 62 may be arranged in the inner of the support member 56. Further, the support member 56 may be transparent to actinic radiation. For example, the support member 56 may at least be partially made of glass or acryl glass.

Further, the control unit 60 may be configured to generate a sequence of exposure cycles in which the radiation source 58 exposes the photosensitive polymer layer 18 through the imaging layer 22 to the actinic radiation. The sequence of exposure cycles may comprise a first set of exposure cycles followed by a second set of exposure cycles, the first set of exposure cycles having a corresponding first set of intensities of the actinic radiation and the second set of exposure cycles having a corresponding second set of intensities of the actinic radiation. Further, wherein the intensity of the actinic radiation within the first set of intensities is lower than the intensity of the actinic radiation within the second set of intensities and/or an energy input to the photosensitive polymer layer 18 by each exposure cycle of the first set of exposure cycles is lower than the energy input of each exposure cycle of the second set of exposure cycles, wherein the second set of exposure cycles comprises equal or more exposure cycles than the first set of exposure cycles, and wherein the energy input of the first set of exposure cycles is about 10% to 30% of the energy input of the sequence of the second set of exposure cycles. Moreover, each exposure cycle of the sequence of exposure cycles may be generated by moving/passing the radiation source 58 along the longitudinal direction L of the printing plate 10, i.e., one pass for each cycle.

Moreover, the first radiation source 58 may comprise a plurality of UV-LEDs which may be arranged in an array form causing a uniform intensity distribution of the actinic radiation on the printing plate 10.

In a preferred configuration, the second set of exposure cycles may comprise at least 1,5 times more exposure cycles than the first set of exposure cycles and/or the sequence of exposure cycles may comprise 7 to 17 exposure cycles.

In a preferred configuration, a respective first exposure time with which each exposure cycle of the first set of exposure cycles exposes an exposed portion of the printing plate with the actinic radiation is equal or higher than a second exposure time with which each exposure cycle of the second set of exposure cycles exposes the exposed portion of the printing plate with the actinic radiation, and preferably, the first exposure time is at least two times higher than the second exposure time.

In a preferred embodiment, the control unit 60 controls the intensity of the actinic radiation within the second set of intensities such that the intensity is at least 5-times higher than the intensity of the actinic radiation within the first set of intensities, and/or the intensity of the actinic radiation within the first set of intensities is substantially constant and/or the intensity of the actinic radiation within the second set of intensities is substantially constant.

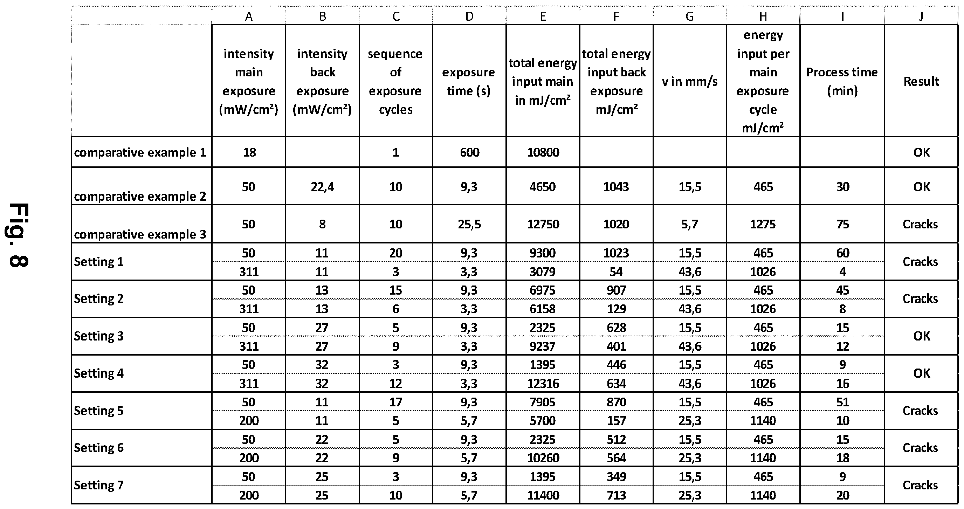

By referring to table A in figure 8, parameters are discussed for determining the intensity of the actinic radiation and exposure time and which avoid formation of cracks in a printing plate. Table A shows three comparative examples 1 to 3, in each of which the intensity remained the same during a sequence of exposure cycles. Further, settings 1 to 7 relate to configurations, where the sequence of exposure cycles comprises a first set of exposure cycles followed by a second set of exposure cycles, and wherein the intensity of the first set of exposure cycles was lower than the intensity of the second set of exposure cycles. Moreover, comparative examples 1 to 3 and settings 1 to 7 relate to the curing of the same type of printing plate.

Further, column A indicates the intensity of the actinic radiation with which the printing plate is exposed and which enters the photosensitive polymer layer 18 through the imaging layer 22 and which is denoted as "main exposure". Column B indicates the intensity of the actinic radiation which optionally enters the photosensitive polymer layer 18 through the substrate layer 22 and which is denoted as "back exposure". Column C lists the number of exposure cycles of the sequence of exposure cycles, wherein for settings 1 to 7, the number of exposure cycles of the sequence of exposure cycles is the sum of the upper and lower value given for the respective setting. Further, the upper value represents the number of exposure cycles of the first set of exposure cycles and the lower value represents the number of exposure cycles of the second set of exposure cycles.

Column D represents the exposure time for each exposure cycle. Specifically, the exposure time specifies the duration the exposure cycle exposes a specific portion of the printing plate to the actinic radiation. In other words, the exposure time is the duration for which a pixel of the printing plate is exposed to the actinic radiation. Further, the upper value represents the exposure time for each exposure cycle of the first set of exposure cycles and the lower value represents the exposure time for each exposure cycle of the second set of exposure cycles. Column E gives information regarding the total energy input for the main exposure, wherein for settings 1 to 7, the upper value is the total energy input of the first set of exposure cycles and the lower value is the total energy input of the second set of exposure cycles. Column F gives information regarding the total energy input for the optional back exposure. Column G presents velocity information regarding the relative movement between the radiation source and the printing plate, e.g., as used for the apparatus of the first and third configuration. It is to be noted that column G is not applicable to the apparatus according to the second configuration, except if the first radiation source 48 of the apparatus 44 according to the second configuration simulates relative motion between the first radiation source 48 and the printing plate 10 by sequentially activating different portions of the first radiation source 48.

Column H represents the energy input per exposure cycle for the main exposure, wherein for settings 1 to 7, the upper value is the energy input for each exposure cycle of the first set of exposure cycles and the lower value is the energy input for each exposure cycle of the second set of exposure cycles. Column I represents durations for the curing process of the printing plate, wherein for settings 1 to 7, the upper value is the duration for the first set of exposure cycles and the lower value is the duration for the second set of exposure cycles. Column J provides information whether the corresponding setting causes formation of cracks in the printing plate.

In comparative example 1, the printing plate 10 has been exposed with an intensity of about 18 mW/cm² for 600 seconds. The comparative example 1 has been performed with a bank exposure apparatus which does not use UV-LEDs for the main exposure. Rather, the bank exposure apparatus uses UV-light fluorescent tubes which may not allow intensity levels as shown for example for settings 3 and 4. Moreover, comparative example 1 does not show formation of cracks in the printing plate.

In comparative example 2, the printing plate 10 has been exposed with an intensity of about 50 mW/cm² using 10 exposure cycles. The comparative example 2 has been performed with an apparatus according to the first or third configuration using UV-LEDs for the main exposure. Moreover, comparative example 2 does not show formation of cracks in the printing plate. However, due to the same intensity of the exposure cycles, the process time is quite long.

In comparative example 3, the printing plate 10 has been exposed with an intensity of about 50 mW/cm² using 10 exposure cycles. The apparatus used for curing the printing plate is the same as for the comparative example 2. However, the increased exposure time with respect to comparative example 2 causes formation of cracks in the printing plate.

The apparatus used for settings 1 to 7 is the same as for the comparative examples 2 and 3. In particular, printing plates cured with settings 3 and 4 showed no formation of cracks. Settings 3 and 4 are characterized in that the intensity of the actinic radiation within the first set of intensities is lower than the intensity of the actinic radiation within the second set of intensities and/or an energy input to the photosensitive polymer layer by each exposure cycle of the first set of exposure cycles is lower than the energy input of each exposure cycle of the second set of exposure cycles, the second set of exposure cycles comprises equal or more exposure cycles than the first set of exposure cycles, and the energy input of the first set of exposure cycles is about 10% to 30% of the energy input of the sequence of exposure cycles. Further, it is advantageous to provide a second set of exposure cycles having an higher intensity as compared to the first set of exposure cycles because the process time can be reduced (cf. comparison between comparative example 2 and settings 3/4).

Moreover, the printing plate used in table A was a printing plate which allows to develop flat top printing features by using low intensity actinic radiation (about 17 mW/cm²), e.g., as in comparative example 1. Specifically, the printing plate is a "nyloflex^{®} FTH 170 Digital" printing plate manufactured by Flint Group or a printing plate similar to the "nyloflex^{®} FTH 170 Digital". Further, it is expected that the parameters of table A also work with a "nyloflex^{®} FTH 114 Digital" printing plate manufactured by Flint Group.

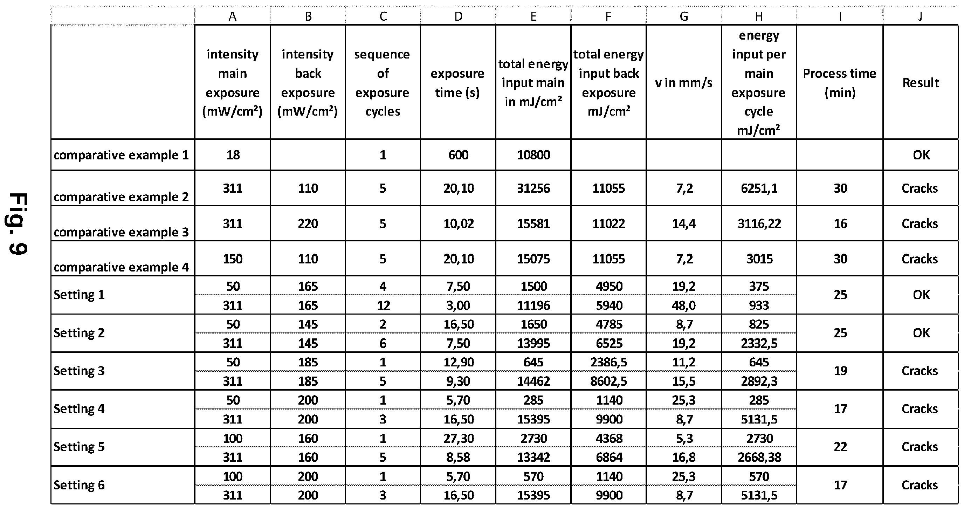

Table B according to figure 9 comprises further examples related to a second type of printing plate, wherein the structure of table B is similar to table A. Comparative example 1 has been performed on an apparatus as used for comparative example 1 of table A. The remaining settings and example have been performed on an apparatus according to the first and second configuration. Settings 1 and 2 have shown no formation of cracks in the printing plate and the findings discussed above with respect to table A apply also to table B. The printing plate used in table B is a "nyloflex^{®} FTS 170 Digital" printing plate manufactured by Flint Group. Further, it is expected that the parameters of table B also work with a "nyloflex^{®} FTS 114 Digital" printing plate manufactured by Flint Group.

Further, the tests shown in tables A and B (except comparative example 1) have been performed by moving the radiation source 36 relative to the printing plate 10 as in the first configuration shown in Fig. 5. The distance the radiation source 36 moves along the longitudinal direction L of the printing plate to scan the entire printing plate 10 is about 2400mm. Further the radiation source needs about 25 seconds to return from one end position to the other.

The invention may also be applicable to other printing plates, e.g., "DuPont^{™} Cyrel^{®} EASY EPC" manufactured by Du Pont, or "LUX^{®} ITP 60" manufactured by MacDermid.

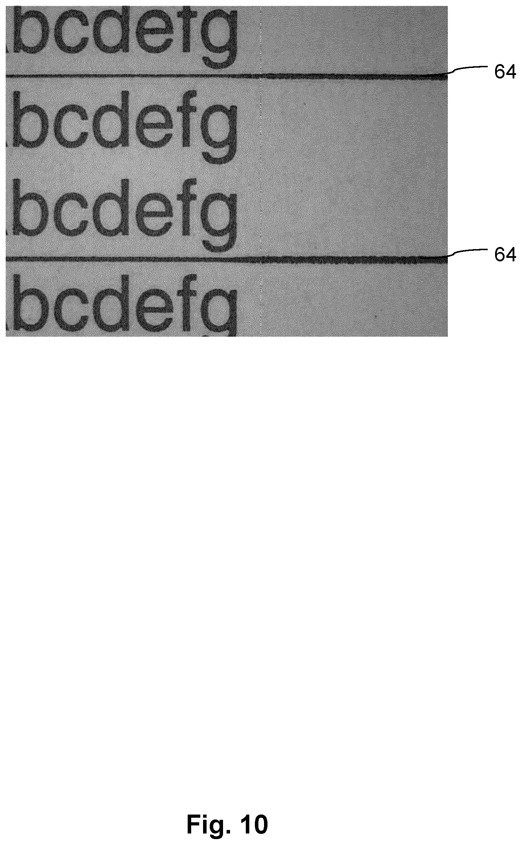

Further, it has been observed that providing a sequence of exposure cycles comprising a first set of exposure cycles followed by a second set of exposure cycles, the first set of exposure cycles having a corresponding first set of intensities of the actinic radiation and the second set of exposure cycles having a corresponding second set of intensities of the actinic radiation, wherein the intensity of the actinic radiation within the first set of intensities is lower than the intensity of the actinic radiation within the second set of intensities and/or an energy input to the photosensitive polymer layer by each exposure cycle of the first set of exposure cycles is lower than the energy input of each exposure cycle of the second set of exposure cycles, wherein the second set of exposure cycles comprises equal or more exposure cycles than the first set of exposure cycles, and wherein the energy input of the first set of exposure cycles is about 10% to 30% of the energy input of the sequence of exposure cycles, may reduce the so called line broadening effect discussed by referring to figure 10.

Line broadening is a problem which is also related to printing plates able to develop flat tops when cured with low intensities (cf. Table A/B comparative example 1). Specifically, thin lines are printed broader than the original line in the image file as soon as they stand alone, i.e. if they are not surrounded by other image details/printing features. Figure 9 shows a print with the line broadening effect. As can be seen in figure 9, the right side of the line 64 is broader than the left side of the line 64. The example shown in the top of figure 9 has been produced by the present invention and reduces the thickness of the right side of line 64 as compared to the example shown at the bottom.

In the following, further features, characteristics and advantages of the invention will be described by means of items:
Item 1. A method for curing a printing plate 10 comprising a photosensitive polymer layer 18 sensitive to actinic radiation and an imaging layer 22 covering the photosensitive polymer layer 18, the method comprising:
   generating with a radiation source 36 a sequence of exposure cycles to expose the photosensitive polymer layer 18 through the imaging layer 22 to actinic radiation radiated from the radiation source,
   wherein the sequence of exposure cycles comprises a first set of exposure cycles followed by a second set of exposure cycles, the first set of exposure cycles having a corresponding first set of intensities of the actinic radiation and the second set of exposure cycles having a corresponding second set of intensities of the actinic radiation,
   wherein the intensity of the actinic radiation within the first set of intensities is lower than the intensity of the actinic radiation within the second set of intensities and/or an energy input to the photosensitive polymer layer 18 by each exposure cycle of the first set of exposure cycles is lower than the energy input of each exposure cycle of the second set of exposure cycles,
   wherein the second set of exposure cycles comprises equal or more exposure cycles than the first set of exposure cycles, and
   wherein the energy input of the first set of exposure cycles is about 10% to 30% of the energy input of the sequence of exposure cycles.
Item 2. The method of item 1, wherein the second set of exposure cycles comprises at least 1,5 times more exposure cycles than the first set of exposure cycles and/or wherein the sequence of exposure cycles comprises 7 to 17 exposure cycles.
Item 3. The method of item 1 or 2, wherein a respective first exposure time with which each exposure cycle of the first set of exposure cycles exposes an exposed portion of the printing plate 10 with the actinic radiation is equal or higher than a second exposure time with which each exposure cycle of the second set of exposure cycles exposes the exposed portion of the printing plate with the actinic radiation, and wherein preferably the first exposure time is at least two times higher than the second exposure time.
Item 4. The method of any one of the preceding items, wherein the intensity of the actinic radiation within the first set of intensities is less or equal than about 300 mW/cm² while the intensity of the actinic radiation within the second set of intensities is higher than about 1200 mW/cm², and
   wherein preferably the intensity of the actinic radiation within the first set of intensities is less or equal than about 100 mW/cm² while the intensity of the actinic radiation within the second set of intensities is higher than about 100 mW/cm².
Item 5. The method of any one of the preceding items, wherein the intensity of the actinic radiation within the second set of intensities is at least 5-times higher than the intensity of the actinic radiation within the first set of intensities, and/or
   wherein the intensity of the actinic radiation within the first set of intensities is substantially constant and/or wherein the intensity of the actinic radiation within the second set of intensities is substantially constant.
Item 6. The method of any one of the preceding items, wherein the first set of exposure cycles comprises 5 exposure cycles having an intensity of about 40 mW/cm² to 60mW/cm², preferable of about 50 mW/cm², and the second set of exposure cycles comprises 9 exposure cycles having an intensity of about 290 mW/cm² to 330 mW/cm², preferably of about 311 mW/cm², or
   wherein the first set of exposure cycles comprises 3 exposure cycles having an intensity of about 40 mW/cm² to 60mW/cm², preferable of about 50 mW/cm², and the second set of exposure cycles comprises 12 exposure cycles having an intensity of about 290 mW/cm² to 330 mW/cm², preferably of about 311 mW/cm², or
   wherein the first set of exposure cycles comprises 4 exposure cycles having an intensity of about 40 mW/cm² to 60mW/cm², preferable of about 50 mW/cm², and the second set of exposure cycles comprises 12 exposure cycles having an intensity of about 290 mW/cm² to 330 mW/cm², preferably of about 311 mW/cm², or
   wherein the first set of exposure cycles comprises 2 exposure cycles having an intensity of about 40 mW/cm² to 60mW/cm², preferable of about 50 mW/cm², and the second set of exposure cycles comprises 6 exposure cycles having an intensity of about 290 mW/cm² to 330 mW/cm², preferably of about 311 mW/cm²
Item 7. The method of any one of the preceding items, wherein the actinic radiation is ultraviolet, UV, radiation and/or wherein the radiation source is an UV-LED radiation source.
Item 8. The method of any one of the preceding items, wherein generating the sequence of exposure cycles comprises providing relative motion between the radiation source 36 and the printing plate 10.
Item 9. The method of any one of the preceding items, further comprising:
   generating one or more additional exposure cycles for exposing the photosensitive polymer layer 18 with actinic radiation through a substrate layer 26 of the printing plate 10.
Item 10. An apparatus 32 for curing a printing plate 10 comprising a photosensitive polymer layer 18 sensitive to actinic radiation and an imaging layer 22 covering the photosensitive polymer layer 18, the apparatus comprising:
   a support member 34 configured to support the printing plate 10;
   a radiation source 36 configured to radiate actinic radiation; and
   a control unit 38 configured to generate a sequence of exposure cycles in which the radiation source 36 exposes the photosensitive polymer layer 18 through the imaging layer 22 to the actinic radiation,
   wherein the sequence of exposure cycles comprises a first set of exposure cycles followed by a second set of exposure cycles, the first set of exposure cycles having a corresponding first set of intensities of the actinic radiation and the second set of exposure cycles having a corresponding second set of intensities of the actinic radiation,
   wherein the intensity of the actinic radiation within the first set of intensities is lower than the intensity of the actinic radiation within the second set of intensities and/or an energy input to the photosensitive polymer layer by each exposure cycle of the first set of exposure cycles is lower than the energy input of each exposure cycle of the second set of exposure cycles,
   wherein the second set of exposure cycles comprises equal or more exposure cycles than the first set of exposure cycles, and
   wherein the energy input of the first set of exposure cycles is about 10% to 30% of the energy input of the sequence of exposure cycles.
Item 11. The apparatus 32 according to item 10, wherein the radiation source 36 comprises a UV-LED radiation source providing UV-light as the actinic radiation.
Item 12. The apparatus 32 according to item 11, wherein the control unit 38 is configured to apply pulse width modulation to a control signal controlling the intensity of the UV-LED radiation source.
Item 13. The apparatus 32 according to any one of items 10 to 12, further configured to generate the sequence of exposure cycles by providing relative motion between the radiation source 36 and the printing plate 10.
Item 14. The apparatus 32 according to any one of items 10 to 13, wherein the support member 46 is a flatbed on which the printing plate 10 can be positioned.
Item 15. A computer-readable medium comprising computer-readable instructions which, when loaded and executed by an apparatus for curing a printing plate comprising a photosensitive polymer layer sensitive to actinic radiation and an imaging layer covering the photosensitive polymer layer, cause the apparatus for curing the printing plate to:
   generate with a radiation source a sequence of exposure cycles to expose the photosensitive polymer layer through the imaging layer to actinic radiation radiated from the radiation source,
   wherein the sequence of exposure cycles comprises a first set of exposure cycles followed by a second set of exposure cycles, the first set of exposure cycles having a corresponding first set of intensities of the actinic radiation and the second set of exposure cycles having a corresponding second set of intensities of the actinic radiation,
   wherein the intensity of the actinic radiation within the first set of intensities is lower than the intensity of the actinic radiation within the second set of intensities and/or an energy input to the photosensitive polymer layer by each exposure cycle of the first set of exposure cycles is lower than the energy input of each exposure cycle of the second set of exposure cycles,
   wherein the second set of exposure cycles comprises equal or more exposure cycles than the first set of exposure cycles, and
   wherein the energy input of the first set of exposure cycles is about 10% to 30% of the energy input of the sequence of exposure cycles.
Item 16. A parameter set comprising exposure parameters for curing a printing plate comprising a photosensitive polymer layer sensitive to actinic radiation and an imaging layer covering the photosensitive polymer layer which, when loaded into an apparatus for curing the printing plate, causes the apparatus for curing the printing plate to:
   generate with a radiation source a sequence of exposure cycles to expose the photosensitive polymer layer through the imaging layer to actinic radiation radiated from the radiation source,
   wherein the sequence of exposure cycles comprises a first set of exposure cycles followed by a second set of exposure cycles, the first set of exposure cycles having a corresponding first set of intensities of the actinic radiation and the second set of exposure cycles having a corresponding second set of intensities of the actinic radiation,
   wherein the intensity of the actinic radiation within the first set of intensities is lower than the intensity of the actinic radiation within the second set of intensities and/or an energy input to photosensitive polymer layer by each exposure cycle of the first set of exposure cycles is lower than the energy input of each exposure cycle of the second set of exposure cycles,
   wherein the second set of exposure cycles comprises equal or more exposure cycles than the first set of exposure cycles, and
   wherein the energy input of the first set of exposure cycles is about 10% to 30% of the energy input of the sequence of exposure cycles.
Item 17. A method for curing a printing plate 10 comprising a photosensitive polymer layer 18 sensitive to actinic radiation and an imaging layer 22 covering the photosensitive polymer layer 18, the method comprising:
   generating, with a radiation source 48 capable of exposing the entire printing plate at the same time with actinic radiation, an exposure cycle to expose the photosensitive polymer layer through the imaging layer to the actinic radiation,
   wherein the exposure cycle comprises at least a first phase and a second phase having a first duration and a second duration, respectively,
   wherein a first intensity of the actinic radiation during the first phase is lower than a second intensity of the actinic radiation during the second phase, and
   wherein an energy input to the photosensitive polymer layer during the first phase is about 10% to 30% of the energy input of the exposure cycle; or
   wherein the intensity of the actinic radiation is at least partially increased over the duration of the exposure cycle and wherein the energy input to the photosensitive polymer layer caused by the exposure cycle cures the printing plate.
Item 18. An apparatus 44 for curing a printing plate 10 comprising a photosensitive polymer layer 18 sensitive to actinic radiation and an imaging layer 22 covering the photosensitive polymer layer 18, the apparatus 44 comprising:
   a support member 46 configured to support the printing plate 10;
   a radiation source 48 configured to expose the entire printing plate 10 at the same time to actinic radiation; and
   a control unit 50 configured to generate an exposure cycle in which the radiation source 48 exposes the photosensitive polymer layer 18 through the imaging layer 22 to the actinic radiation,
   wherein the exposure cycle comprises at least a first phase and a second phase having a first duration and second duration, respectively,
   wherein a first intensity of the actinic radiation during the first phase is lower than a second intensity of the actinic radiation during the second phase, and
   wherein an energy input to the photosensitive polymer layer during the first phase is about 10% to 30% of the energy input of the exposure cycle; or
   wherein the intensity of the actinic radiation is at least partially increased over the duration of the exposure cycle and wherein the energy input to the photosensitive polymer layer caused by the exposure cycle cures the printing plate.
Item 19. A computer-readable medium comprising computer-readable instructions which, when loaded and executed by an apparatus for curing a printing plate comprising a photosensitive polymer layer sensitive to actinic radiation and an imaging layer covering the photosensitive polymer layer, cause the apparatus for curing the printing plate to:
   generate, with a radiation source capable of exposing the entire printing plate at the same time with actinic radiation, an exposure cycle in which the radiation source exposes the photosensitive polymer layer through the imaging layer to the actinic radiation,
   wherein the exposure cycle comprises at least a first phase and a second phase having a first duration and second duration, respectively,
   wherein a first intensity of the actinic radiation during the first phase is lower than a second intensity of the actinic radiation during the second phase, and
   wherein an energy input to the photosensitive polymer layer during the first phase is about 10% to 30% of the energy input of the exposure cycle; or
   wherein the intensity of the actinic radiation is at least partially increased over the duration of the exposure cycle and wherein the energy input to the photosensitive polymer layer caused by the exposure cycle cures the printing plate.
Item 20. A parameter set comprising exposure parameters for curing a printing plate comprising a photosensitive polymer layer sensitive to actinic radiation and an imaging layer covering the photosensitive polymer layer which, when loaded into an apparatus for curing the printing plate, causes the apparatus for curing the printing plate to:
   generate, with a radiation source capable of exposing the entire printing plate at the same time with actinic radiation, an exposure cycle in which the radiation source exposes the photosensitive polymer layer through the imaging layer to the actinic radiation,
   wherein the exposure cycle comprises at least a first phase and a second phase having a first duration and second duration, respectively,
   wherein a first intensity of the actinic radiation during the first phase is lower than a second intensity of the actinic radiation during the second phase, and
   wherein an energy input to the photosensitive polymer layer during the first phase is about 10% to 30% of the energy input of the exposure cycle; or
   wherein the intensity of the actinic radiation is at least partially increased over the duration of the exposure cycle and wherein the energy input to the photosensitive polymer layer caused by the exposure cycle cures the printing plate.

### List of Reference Numerals

- 10: printing plate
- 12: cracks
- 14: first portion of printing plate
- 16: second portion of printing plate
- 18: photosensitive polymer layer
- 20: printing features
- 22: imaging layer
- 24: ablated portions
- 26: substrate layer
- 28: conical body
- 30: flat top surface
- 32: apparatus (first configuration)
- 34: support member
- 36: radiation source
- 38: control unit
- 40: pulse width modulation unit
- 42: drive unit
- 44: apparatus (second configuration)
- 46: support member
- 48: first radiation source
- 50: control unit
- 52: second radiation source
- 54: apparatus (third configuration)
- 56: support member
- 58: first radiation source
- 60: control unit
- 62: second radiation source
- 64: line
- L: longitudinal direction
- T: transverse direction

## Claims

1. An apparatus (32) for curing a printing plate (10) comprising a photosensitive polymer layer (18) sensitive to actinic radiation and an imaging layer (22) covering the photosensitive polymer layer (18), the apparatus comprising:
a support member (34) configured to support the printing plate (10);
a radiation source (36) configured to radiate actinic radiation with a first intensity being less than 100 mW/cm² or a second intensity being higher than 100 mW/cm²; and
a control unit (38) configured to control the intensity of the actinic radiation radiated from the radiation source (36),
wherein the control unit (38) is configured to generate a first set of exposure cycles followed by a second set of exposure cycles for exposing the photosensitive polymer layer (18) through the imaging layer (22) to the actinic radiation,
wherein the first set of exposure cycles is applied at the first intensity and the second set of exposure cycles is applied at the second intensity.

2. The apparatus of claim 1, wherein the apparatus is configured such that the second set of exposure cycles comprises equal or more exposure cycles than the first set of exposure cycles, and/or
wherein the energy input of the first set of exposure cycles is about 10% to 30% of the energy input of a sequence of exposure cycles comprising the first and second set of exposure cycles.

3. The apparatus (32) according to claim 1 or 2, wherein the radiation source (36) comprises a UV-LED radiation source providing UV-light as the actinic radiation, and/or
wherein the first intensity is between 40 mW/cm² and 60 mW/cm².

4. The apparatus (32) according to any one of claims 1 to 3, further configured to generate the first and second set of exposure cycles by providing relative motion between the radiation source (36) and the printing plate (10).

5. A method for curing a printing plate (10) comprising a photosensitive polymer layer (18) sensitive to actinic radiation and an imaging layer (22) covering the photosensitive polymer layer (18), the method comprising:
generating with a radiation source (36) a first set of exposure cycles followed by a second set of exposure cycles to expose the photosensitive polymer layer (18) through the imaging layer (22) to actinic radiation radiated from the radiation source,
wherein the radiation source is configured to radiate the actinic radiation with a first intensity being less than 100 mW/cm² or a second intensity being higher than 100 mW/cm², and
wherein the first set of exposure cycles is applied at the first intensity and the second set of exposure cycles is applied at the second intensity.

6. The method of claim 5, wherein the second set of exposure cycles comprises equal or more exposure cycles than the first set of exposure cycles, and/or
wherein the energy input of the first set of exposure cycles is about 10% to 30% of the energy input of a sequence of exposure cycles comprising the first and second set of exposure cycles.

7. The method of claim 5 or 6, wherein the radiation source (36) comprises a UV-LED radiation source providing UV-light as the actinic radiation, and/or
wherein the first intensity is between 40 mW/cm² and 60 mW/cm².

8. The method of any one of claims 5 to 7, wherein the first and second set of exposure cycles are generated by providing relative motion between the radiation source (36) and the printing plate (10).

9. A computer-readable medium comprising computer-readable instructions which, when loaded and executed by an apparatus for curing a printing plate comprising a photosensitive polymer layer sensitive to actinic radiation and an imaging layer covering the photosensitive polymer layer, cause the apparatus for curing the printing plate to:
generate with a radiation source (36) a first set of exposure cycles followed by a second set of exposure cycles to expose the photosensitive polymer layer (18) through the imaging layer (22) to actinic radiation radiated from the radiation source,
wherein the radiation source is configured to radiate the actinic radiation with a first intensity being less than 100 mW/cm² or a second intensity being higher than 100 mW/cm², and
wherein the first set of exposure cycles is applied at the first intensity and the second set of exposure cycles is applied at the second intensity.

10. The computer-readable medium of claim 9, further comprising computer-readable instructions causing the apparatus that the second set of exposure cycles comprises equal or more exposure cycles than the first set of exposure cycles, and/or
that the energy input of the first set of exposure cycles is about 10% to 30% of the energy input of a sequence of exposure cycles comprising the first and second set of exposure cycles.

11. The computer-readable medium of claim 9 or 10, wherein the radiation source (36) comprises a UV-LED radiation source providing UV-light as the actinic radiation, and/or
wherein the first intensity is between 40 mW/cm² and 60 mW/cm².

12. The computer-readable medium of any one of claims 9 to 11, further comprising computer-readable instructions causing the apparatus that the first and second set of exposure cycles are generated by providing relative motion between the radiation source (36) and the printing plate (10).

13. Use of an apparatus (32) for curing a printing plate (10) comprising a photosensitive polymer layer (18) sensitive to actinic radiation and an imaging layer (22) covering the photosensitive polymer layer (18), the apparatus comprising:
a support member (34) configured to support the printing plate (10);
a radiation source (36) configured to radiate actinic radiation with a first intensity being less than 100 mW/cm² or a second intensity being higher than 100 mW/cm²; and
a control unit (38) configured to control the intensity of the actinic radiation radiated from the radiation source (36),
wherein the use comprises using the control unit (38) to generate a first set of exposure cycles followed by a second set of exposure cycles for exposing the photosensitive polymer layer (18) through the imaging layer (22) to the actinic radiation,
wherein the first set of exposure cycles is applied at the first intensity and the second set of exposure cycles is applied at the second intensity.

14. The use of claim 13, wherein the second set of exposure cycles comprises equal or more exposure cycles than the first set of exposure cycles, and/or
wherein the energy input of the first set of exposure cycles is about 10% to 30% of the energy input of a sequence of exposure cycles comprising the first and second set of exposure cycles.

15. The use of claim 13 or 14, wherein the first and second set of exposure cycles are generated by providing relative motion between the radiation source (36) and the printing plate (10), and/or
wherein the first intensity is between 40 mW/cm² and 60 mW/cm².
